(19) Europäisches Patentamt
European Patent Office
Office européen des brevets

(11) **EP 4 134 745 A1**

(12) **EUROPEAN PATENT APPLICATION**

(43) Date of publication:
**15.02.2023 Bulletin 2023/07**

(21) Application number: **21191008.8**

(22) Date of filing: **12.08.2021**

(51) International Patent Classification (IPC):
**G03F 7/20** (1968.09)     **G03F 9/00** (1968.09)

(52) Cooperative Patent Classification (CPC):
**G03F 9/7092; G03F 7/705; G03F 7/70633**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **TEN HAAF, Gijs**
**5500 AH Veldhoven (NL)**

• **ROOZE, Joost**
**5500 AH Veldhoven (NL)**
• **TRAN, Vu, Quang**
**5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16-50 are deemed to be abandoned due to non-payment of the claims fees (Rule 45(3) EPC).

(54) **A METHOD FOR MODELING MEASUREMENT DATA OVER A SUBSTRATE AREA AND ASSOCIATED APPARATUSES**

(57) Disclosed is a method for modeling alignment data over a substrate area relating to a substrate being exposed in a lithographic process. The method comprises obtaining alignment data relating to said substrate and separating the alignment data into a systematic component which is relatively stable between different substrates and a non-systematic component which is not relatively stable between different substrates. The systematic component and the non-systematic component are individually modeled and a process correction for the substrate determined based on the modeled systematic component and modeled non-systematic component.

Fig. 4

## Description

FIELD

The present disclosure relates to processing of substrates for the production of, for example, semiconductor devices.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-kl lithography may be used to process features with dimensions smaller than the classical resolution limit of a lithographic apparatus. In such a process, the resolution formula may be expressed as CD = $k1\lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by measurement data associated with mark position. The measurement data are obtained from measurements of wafers. An example of such measurements are alignment measurements of alignment marks performed using an alignment system in a lithographic apparatus prior to exposure.

It would be desirable to improve modeling of these distortions.

SUMMARY

In a first aspect of the invention there is provided a method for modeling alignment data over a substrate area relating to a substrate being exposed in a lithographic process, the method comprising: obtaining alignment data relating to said substrate; separating the alignment data into a systematic component which is relatively stable between different substrates and a non-systematic component which is not relatively stable between different substrates; individually modeling the systematic component and the non-systematic component; and determining a process correction for the substrate based on the modeled systematic component and modeled non-systematic component.

In a second aspect of the invention there is provided a method for modeling alignment data over a substrate area relating to a substrate being exposed in a lithographic process, the method comprising: obtaining alignment data relating to said substrate; determining a systematic component of said alignment data which is relatively stable between different substrates; and individually modeling the systematic component.

In a further aspect of the invention, there is provided a computer program comprising program instructions operable to perform the method of the first aspect when run on a suitable apparatus, and associated processing apparatus and lithographic apparatus.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;

Figure 2 depicts a schematic overview of a lithographic cell;

Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention;

Figure 4 is a flow diagram describing a method for implementing alignment feedback according to a first embodiment; and

Figure 5 is a flow diagram describing a method for implementing alignment feedback according to a second embodiment.

DETAILED DESCRIPTION

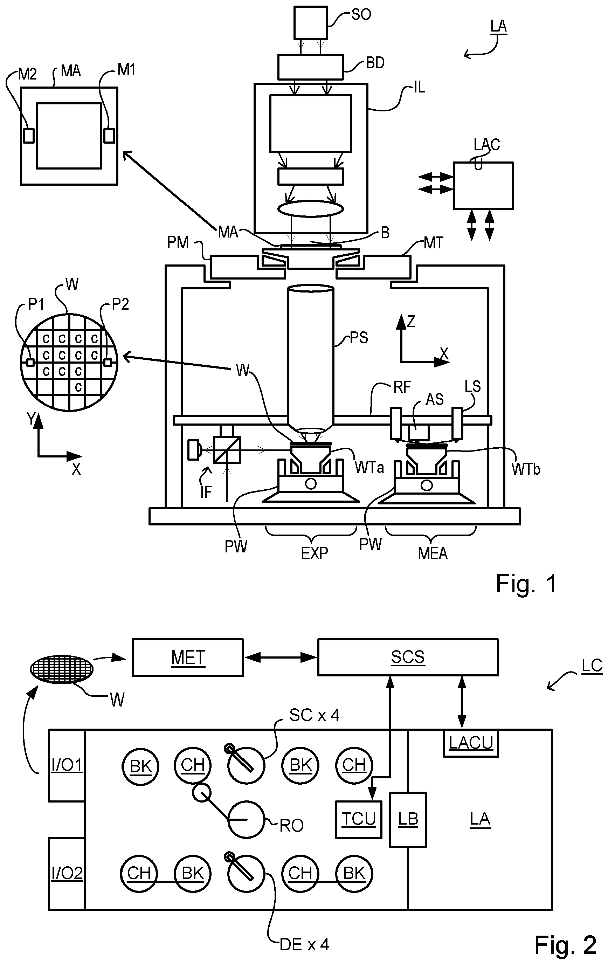

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement stationbetween which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

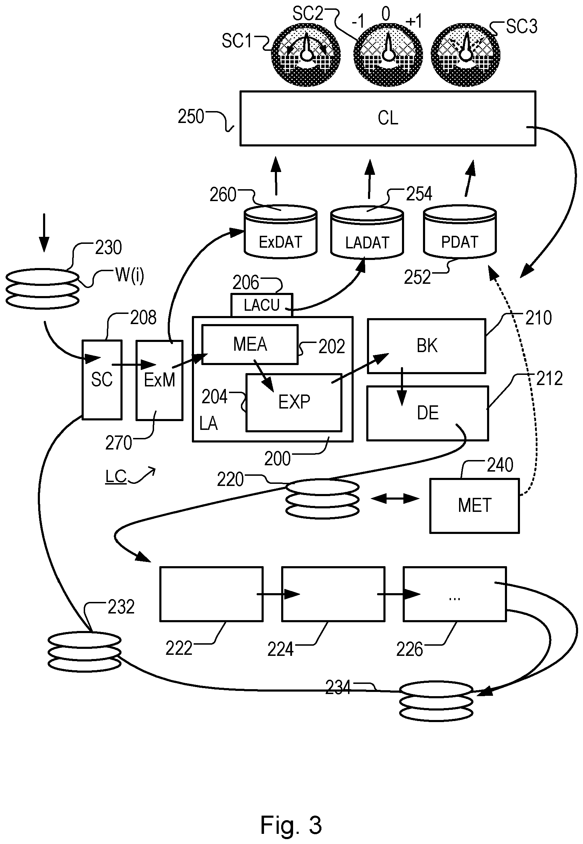

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a 'dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist.

Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Increasingly, (e.g. stand-alone) external pre-exposure metrology tools ExM 270 are used to make measurements before exposure on a lithographic apparatus. Such external pre-exposure metrology tools ExM 270 are distinct from the measurement station MEA 202 of a twin stage lithographic apparatus LA 200. Any pre-exposure measurements performed within the track are also considered to be external measurements. To maintain exposure throughput at a sufficient level, the scanner metrology data LADAT (e.g., alignment grid and substrate deformation grid) measured by measurement station MEA 202 is based on a sparser set of measurements as would be desirable. This typically means such a measurement station is incapable of gathering sufficient measurement data for higher order corrections, and particularly corrections beyond the third order. In addition to this, use of an opaque hard mask can make it difficult to accurately measure the wafer grid in alignment.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each exposure field. The measurement data will be sparse as it is simply not practical to measure as many measurement regions as would be desirable from an overlay accuracy perspective: the time and therefore throughput overhead would be too high. A second purpose of an alignment model is to provide noise suppression. This may be achieved by using fewer model parameters than measurements or by using regularization.

While standard models might use fewer than ten parameters, advanced alignment models typically use more than 15 parameters, or more than 30 parameters. Examples of advanced models are higher order wafer alignment (HOWA) models and radial basis function (RBF) based alignment models. HOWA is a published technique based on second and higher order polynomial functions. RBF modeling is described in US2012218533A1, which is incorporated herein by reference. Different versions and extensions of these advanced models can be devised. The advanced models generate a complex description of the wafer grid that is corrected for, during the exposure of the target layer. RBF and latest versions of HOWA provide particularly complex descriptions based on tens of parameters. This implies many measurements are required to obtain a wafer grid with sufficient accuracy.

RBF modeling is an extrapolation/interpolation modeling technique able to capture localized wafer deformations better than polynomial models. The type of RBF model described in detail in US2012218533A1 is known as a thin plate spline model. This model is a functional minimizing spline, where the functional being minimized comprises an integral of a density function that depends on the second derivatives of the model.

Present wafer alignment strategies provide a feedforward wafer grid correction based on alignment sensor measurements (alignment data) performed, for every wafer, on alignment marks printed in a previous exposure. The main goal of wafer alignment is to minimize overlay with a previous layer.

Typically, overlay measurements (post exposure metrology) may be performed on a (relatively small) subset of the exposed product wafers for every lot, so as to determine corrections for future wafers. These are corrections determined in addition to the wafer alignment corrections, and correct the (moving) average error of the wafer grid correction determined by wafer alignment. This may be referred to as on-product overlay control.

A further correction strategy, which may be used in addition to wafer alignment and on-product overlay control, comprises a machine overlay calibration (stability monitoring application) that is frequently updated; e.g., typically every few days. Such a stability monitoring application may provide corrections for both the alignment measurements and the expose grid. In contrast to on-product overlay control, stability monitoring is based on measurements of calibration wafers.

Wafer alignment is not perfect. For example, it suffers from systematic measurement errors which differ between alignment marks on a single wafer, but are largely the same between wafers. In addition, wafer alignment may suffer from model interpolation and/or extrapolation errors which incorrectly translates the (partly systematic) alignment wafer grid from the sparse set of alignment measurements to a full wafer correction.

The systematic component of the wafer alignment errors can be corrected by on-product overlay control provided that the alignment "recipe" is constant, where the alignment recipe describes the combination of all alignment measurement and model parameters, such as *inter alia:* measurement wavelength(s)/polarization(s), measurement layout/sampling scheme, alignment model used. More specifically, as the systematic component does not vary significantly between wafers, it defines essentially a systematic wafer grid error. This systematic wafer grid error can be measured from the exposed wafer (e.g., via offline overlay metrology) and corrected for in subsequent wafers.

However, with known wafer alignment architectures, this type of correction is not possible if the alignment recipe is varied and is not stable. The systematic wafer alignment error depends on the recipe, so if this recipe differs from the recipe used to determine the on-product overlay control corrections, the determined corrections will not be correct. Furthermore, the systematic wafer grid error is product dependent. Mark deformations and wafer grid interpolation and extrapolation errors are influenced by processing steps. These effects mean that the machine overlay control (stability monitoring) cannot immediately correct for these errors.

One consequence of this is that there is a tendency to avoid changing an alignment recipe during a process that is controlled with on-product overlay metrology. The change in the systematic wafer grid error resultant from such a recipe change leads to what is sometimes termed as a wafers in progress (WIP) overlay penalty. This reluctance to change the recipe is observed even when a recipe change would be beneficial for reducing on-product overlay variation.

The WIP impact attributable to changing an alignment model depends on the change itself and on the average alignment fingerprint. By way of a specific example, it may be desirable to change from a regularized (e.g., RBF) alignment model to an unregularized (or differently regularized (e.g., RBF) alignment model (or *vice versa*). A motivation for changing the regularization could be for example a change or drift in the lithography or other processing equipment, leading to wafer distortions of a different nature..

A specific example of the tendency to keep the recipe unchanged is a known reluctance to switch on wafer alignment model mapping (WAMM), which is a training method based on on-product overlay and alignment data that is shown to improve on-product overlay variation. WAMM is described in US patent US10331040B2, which is hereby incorporated by reference. A large number of training wafers (typically 100+) is required for the method to work well, which may not be available (or desirable to use) at the start of production. However, switching WAMM on after production has started (e.g., once data from a sufficient number of wafers has been collected), or updating WAMM after a time to accommodate a changing process, results in a WIP overlay penalty and is therefore commonly avoided.

For the same reason, it is often undesirable with the current architecture, to implement adaptive wafer alignment color recipe and modelling, i.e., change the color recipe/model on a wafer-by-wafer basis, based on measurements from that same wafer. The systematic wafer grid error propagation of such changes cannot be corrected with on product overlay control. However, there can also be benefits of changing the wafer alignment color recipe and model per wafer. The color recipe could be chosen per wafer to better suppress the error due to alignment mark deformations on individual wafers or the modelling can be optimized per wafer to better accommodate the wafer grid distortion of individual wafers. A motivation for such an adaptive strategy could be due to there being a different level of wafer grid distortions on different wafers. When a wafer suffers from a larger wafer grid distortion than is typical, it can be beneficial to regularize that wafer less to follow the distortion better. The overlay penalty of a dynamically changing alignment model is similar to the WIP overlay penalty already described (i.e., when the change is only done once).

There is also a disadvantage of the current known wafer alignment architectures related to measurement invalidation (either in residual outlier removal or by means of secondary measurement KPIs). When a measurement is invalidated and removed from the data, the layout on which the model is fitted is effectively changed by its removal. This causes a penalty because of a change in systematic wafer grid error propagation.

Finally, outlier detection is typically based on wafer alignment modelling residuals, which contain a significant systematic component which is the same for every wafer. This systematic component makes the distribution of residuals broader than if it were not there. This makes detecting an outlier more difficult than if would not be present.

To address the issues raised, it is proposed to introduce a wafer alignment feedback loop, that calculates the systematic component of historic on-product alignment data and feeds back this systematic component to new wafers of the same kind (exposure recipes and alignment layout) in order to separate the systematic component of the alignment data from the varying or non-systematic component in the alignment data. The systematic component may then be monitored and modeled with a stable alignment recipe; e.g., a stable layout (e.g., no outlier removal), color/polarization and modelling recipe, such that the systematic wafer grid error is maintained stable and can be corrected with on-product overlay control. The non-systematic component may be treated differently to the systematic component when appropriate or beneficial. In particular, the alignment recipe for the non-systematic component may be varied during runtime when deemed beneficial, without incurring a WIP impact; for example: by using a reduced layout, e.g., with an outlier removed or layout varied for another reason, using a different model and/or using a different color/polarization recipe.

A prepare model may be used to prepare the alignment data. The prepare model may be parameterized such that, when fitted to the alignment data, it describes the majority of varying component of the alignment data fitted. This fitted model can then be removed from the alignment data, and the moving average of the remaining prepare model residuals can be calculated. This moving average of the prepare model residuals (e.g., comprising the estimated systematic component of the alignment data) can then be subtracted from the alignment data of a subsequent lot, such that only the varying component remains.

This varying component can be modeled as normal (using any suitable alignment model), with the benefit of having flexibility to change the alignment recipe during a run (between lots) or lot (between wafers) without incurring a WIP penalty. The moving average (i.e., the systematic component) can also be modeled as normal, but with a stable alignment recipe (i.e., same mark layout, alignment model and color/polarization recipe). The moving average may be calculated and corrected per alignment mark. The moving average may be calculated and corrected for additionally per one or more of: measurement radiation color, measurement radiation polarization, diffraction order, direction, chuck, exposure recipe and measurement layout. The model coefficients from modelling the systematic component and the varying component can be used together to determine alignment corrections (e.g., correction-per-exposure).

In the context of this disclosure, changing the alignment recipe may comprise a change in one or more of: layout (e.g., to use a reduced layout), model, regularization, color and/or polarization and/or diffraction order recipe, fit weights (the model fit may optionally be a weighed fit, and the fit weights may be the weights given to the respective measurements in the model fit).

The prepare model may be a simpler model than the models used for the main modelling steps. For example, it may be of a lower order than the models used for the main modelling steps (should these use a higher order alignment model, which is optional). For example the prepare model may be a linear model, such as a 4 parameter model (e.g., translation (x and y), rotation and wafer magnification). Of course, other models may be used, e.g., a standard linear 6 parameter model. The aforementioned 4 parameter model, for example, may be sufficient to capture most of the varying component in the alignment data which is usually attributable to wafer load, since it is these parameters which typically show the greatest variation between wafers (e.g. on the order of microns).

This wafer alignment feedback strategy may be implemented within an internal control application in the lithographic apparatus/scanner or within an external control application in e.g. an off-tool computational server. Such an external control application and off-tool computational server may already be present and used, for example, for one or more of: scanner recipe optimization, advanced overlay process control with accurate fingerprint estimation and optimized scanner correction (e.g., feedforward and/or feedback corrections based on overlay metrology to improve the on-product overlay performance).

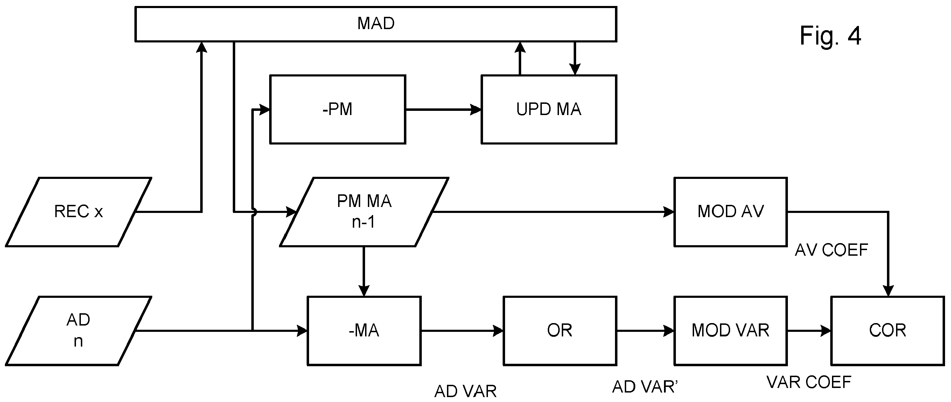

Figure 4 is a flow diagram describing a feedback alignment modeling method based on an internal control application. A moving average database MAD determines and tracks the moving average, based on exposure recipe x REC x and alignment data AD. More specifically, in previous lots (e.g., up to lot n-1, where lot n is the present lot), the alignment data has been modeled using a prepare model, with the fitted prepare model removed from the alignment data -PM. The resultant residuals (i.e., the alignment data with the fitted prepare model removed) is then used to update the moving average UPD MA of these prepare model residuals.

For lot n, the alignment data AD n is obtained. The moving average of the prepare model residuals/systematic component MA n-1 is subtracted -MA from the alignment data AD n, leaving the varying or non-systematic component AD VAR of the alignment data. This can then undergo an (optional) outlier removal step OR to provide a processed non-systematic component without outliers AD VAR'. This non-systematic component AD VAR or AD VAR' is then modelled MOD VAR using a suitable alignment model. This alignment model may be varied as required, e.g., by implementing WAMM, different color/polarization recipes, different modeling strategies etc.. The moving average MA n-1 removed at step -MA, comprising the systematic component of the alignment data, is itself modeled MOD AV using a suitable alignment model which is maintained stable throughout the run. The model coefficients AV COEF from this modeling step MOD AV, and the model coefficients VAR COEF from the non-systematic modeling step are then used together to determine an alignment correction COR.

In addition, as with the previous lots, the alignment data AD n is also modeled using the prepare model and the fitted prepare model removed from the alignment data -PM, with the resultant residuals used to update the moving average UPD MA of these prepare model residuals.

As such, each of the steps may be implemented within the scanner in this embodiment. The control application supplies the moving average of the prepare model wafer alignment residuals of previous lots with the same recipe. The moving average is subtracted from the wafer alignment measurements before the outlier removal and wafer alignment modelling is performed, the latter possibly with a dynamic or changed wafer alignment model or color recipe. On a separate path the moving average that was corrected from the measurements, is also modeled itself with stable model, layout and color recipe. Finally, both sets of model coefficients are evaluated for correction per exposure. After every lot the wafer alignment data of that lot is used to update the moving average of the recipe that was used which will then be used for the next lot.

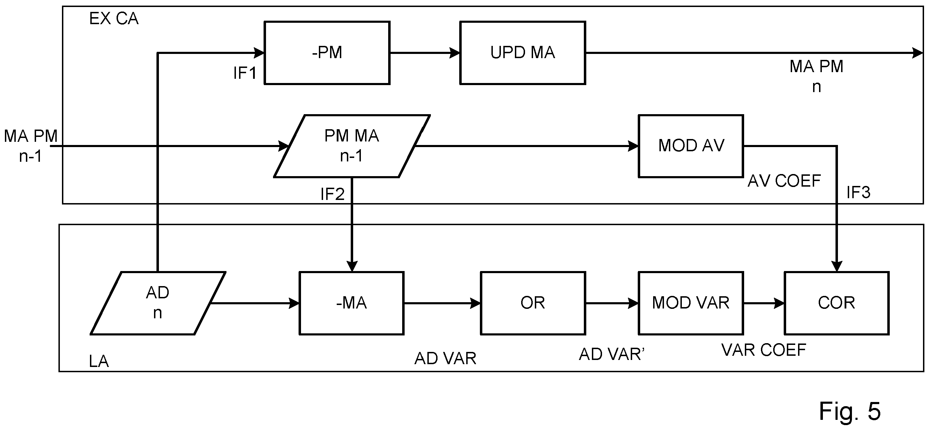

Figure 5 is a flow diagram describing a feedback alignment modeling method based on using an external control application EX CA, which is external to the scanner LA. The basic steps are the same as that of Figure 4 and will not be explained again. The difference in this embodiment is that the moving average is calculated and stored on an offline external control application EX CA, e.g., on an external server. This requires an additional interface IF2 between scanner LA and the external server running the application EX CA, compared to the interfaces present on such an external control server when used for present applications. Interfaces IF1 and IF3 are existing interfaces.

In all embodiments, the weighted average may comprise, for example, an exponentially weighted moving average (EWMA). By way of specific example, the EMWA may be calculated according to:

$$MA_N = (1 - \lambda)MA_{N-1} + \lambda A_N$$

where $MA_N$ is the moving average up to lot N, $A_N$ is the average of lot N and $\lambda$ is a constant parameter (weight).

The advantages of this concept is that on-product overlay corrections can still be applied for the systematic component, while there is greater flexibility in alignment modeling and alignment recipe selection for the non-systematic component, without reducing the effectiveness of the on-product overlay corrections.

For the specific example of outlier removal, the advantages are twofold. The first advantage is the prevention of a change in systematic wafer grid error propagation that causes an overlay penalty on a wafer on which an invalid measurement is present. This overlay penalty depends on the average fingerprint of the alignment measurements and which of the marks is removed. The second advantage is the resultant reduction in residual distribution width, which improves outlier detection. Outlier removal is typically performed on the residuals of the wafer alignment model, by invalidating measurements above an absolute or relative threshold. Therefore, it is easier to distinguish outliers from regular measurements if the alignment residuals are lower. It can be expected that the standard deviation of alignment residuals can be decreased by 15-80% (typical value -45%) by taking out the systematic component, which means that the outlier removal is more sensitive.

In the above, alignment data may comprise, for example, a position value per measured point (per alignment mark) and/or model fit coefficients. Also, feedback of other (than position) wafer alignment measurements, e.g., such as detection signal strength, diffraction order intensity, etc. is envisaged within the context of this disclosure.

In an embodiment, a moving variation performance metric or moving variation key performance indicator (KPI) may be determined. Such a moving variation KPI $\sigma_{i,t+1}^2$ may be determined per alignment mark. The moving variation KPI may be determined for additionally per one or more of: measurement radiation color, measurement radiation polarization, diffraction order, direction, chuck, exposure recipe and measurement layout. Such a moving variation KPI may take the form of, for example:

$$\sigma_{i,t+1}^2 = (1 - \alpha) \times \sigma_{i,t}^2 + \alpha \times \left(res_{var,i,t+1}\right)^2$$

where $res_{var,i,t+1}$ is the residual of the alignment model (for the varying component) of the alignment measurement that has already been corrected for the moving average (of measurement location i and sequence number t+1) and $\alpha$ is a constant parameter (weight).

This moving variation KPI can be used in determining future corrections, e.g. for outlier removal or weighted fitting. For example, outlier removal may be performed in which the outliers are determined by comparing the magnitude of residuals abs($res_{var,i}$) against $n * \sigma_i$ in which i refers to the measurement location and n is a setting. A measurement may be invalidated if abs($res_{var,i,t+1}$) > n * $\sigma_{i,t}$.

Alternatively or in addition, outlier removal may be performed in which a variation metric or variation KPI $\sigma_s$ (for example a standard deviation) of scaled residuals is determined over the wafer, or over a limited area of the wafer. These scaled residuals $sres_i$ may take the form of:

$$sres_{i,t+1} = res_{var,i,t+1}/\sigma_{i,t}.$$

As such, after the scaled residuals $sres_i$ have been determined, the standard deviation $\sigma_s$ of all $sres_i$ on the wafer (or a limited area of the wafer) may be determined. The scaled residuals $sres_{i,t+1}$ can then for example be compared to $n * \sigma_s$ to determine measurements to be invalidated. A measurement may be invalidated if abs($sres_{i,t+1}$) > n * $\sigma_s$.

Alternatively, the moving variation KPI and/or the scaled residuals may be used to determine fit weights per measurement i that subsequently are used in a weighted model fit of the data.

In an embodiment, a robustness defense mechanism may be included in order to prevent feedback loop corruption. A first such mechanism may be a manual mechanism, which may comprise incorporating an overruling or restart setting in exposure settings (e.g., such an overrule may prevent application of wafer alignment feedback or a restart may trigger restarting the feedback loop). An overrule may be implemented, for example, when a special lot, with a different fingerprint, is being exposed. A restart may be implemented if a significant process change has happened which could cause a permanent fingerprint change (e.g. a change in wafer processing or a hardware replacement in the scanner). Alternatively or in combination, the robustness defense mechanism may be an automatic mechanism. For example, such a mechanism may prevent performance of feedback corrected modelling when x number of prepare model residuals $pmres_i$ are outside a range, e.g., as set by

$$MA_i + n * \sigma_i^2$$

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, nonexclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1.  A method for modeling alignment data over a substrate area relating to a substrate being exposed in a lithographic process, the method comprising:

    obtaining alignment data relating to said substrate;
    separating the alignment data into a systematic component which is relatively stable between different substrates and a non-systematic component which is not relatively stable between different substrates; individually modeling the systematic component and the non-systematic component; and
    determining a process correction for the substrate based on the modeled systematic component and modeled non-systematic component.

2.  A method as claimed in claim 1, wherein the separation step is implemented by a feedback loop based on alignment data of previous substrates.

3.  A method as claimed in claim 2, wherein said feedback loop comprises feedback of said systematic component of the alignment data.

4.  A method as claimed in any preceding claim, wherein said separation step is implemented by subtracting a moving average of the alignment data of previous substrates.

5.  A method as claimed in claim 4, comprising determining said moving average from the alignment data of previous substrates.

6. A method as claimed in claim 5, wherein said previous substrates are previous substrates of the same production run.

7. A method as claimed in claim 5 or 6, wherein said step of determining said moving average comprises:

fitting a prepare model to respective alignment data from each said previous substrate; subtracting the fitted prepare model from its respective alignment data, to leave prepare model residuals; and determining the moving average as a moving average of the prepare model residuals.

8. A method as claimed in claim 7, wherein the prepare model is parameterized to describe most of the non-systematic component of said alignment data when fitted to the alignment data.

9. A method as claimed in claim 7 or 8, wherein the prepare model is a linear model.

10. A method as claimed in any of claims 7 to 9, wherein the prepare model is a four parameter model.

11. A method as claimed in claim 10, wherein the four parameter model is parameterized by translation in a first direction in a substrate plane, translation in as second direction in a substrate plane, rotation and substrate magnification.

12. A method as claimed in any of claims 5 to 11, wherein said moving average is determined per alignment mark on the substrate.

13. A method as claimed in any of claims 5 to 12, wherein said moving average is determined per one or more of: measurement radiation wavelength, measurement radiation polarization, diffraction order, direction, chuck, exposure recipe and measurement layout.

14. A method as claimed in any of claims 4 to 13, comprising updating the moving average of said alignment data relating to said substrate after the lithography exposure of each wafer and/or lot of wafers.

15. A method as claimed in any of claims 4 to 14, wherein said moving average is an exponentially weighted moving average.

16. A method as claimed in any preceding claim, wherein said individually modeling of the systematic component comprises modeling said systematic component according to a same alignment recipe as has been used to model the systematic component of all previous substrates of a present production run.

17. A method as claimed in any preceding claim, comprising an outlier removal step to remove outliers from the alignment data, said outlier removal step being performed on said non-systematic component only.

18. A method as claimed in any preceding claim, further comprising determining a moving variation metric per alignment mark on the substrate.

19. A method as claimed in claim 18, wherein said moving variation metric is a weighted moving variation metric.

20. A method as claimed in 18 or 19, wherein said moving variation metric is determined per one or more of: measurement radiation wavelength, measurement radiation polarization, diffraction order, direction, chuck, exposure recipe and measurement layout.

21. A method as claimed in any of claims 18 to 20, wherein said moving variation metric is determined from residuals of said modeling of said non-systematic component.

22. A method as claimed in claim 21, comprising using said moving variation metric to identify outliers, by comparing a magnitude of said residuals of said modeling of said non-systematic component to said moving variation metric or a dependent metric.

23. A method as claimed in any of claims 18 to 22, comprising using said moving variation metric to determining weights for a weighted fitting in at least on of said modeling steps.

24. A method as claimed in any preceding claim, further comprising determining a variation metric from scaled residuals of said modeling of said non-systematic component over said substrate or area thereof.

25. A method as claimed in claim 24, wherein said variation metric comprises a standard deviation of said scaled residuals and the method further comprises comparing the variation metric or a metric dependent thereon to a magnitude of said scaled residuals to identify outliers.

26. A method as claimed in any preceding claim, comprising a robustness defense mechanism in order to prevent feedback loop corruption, said robustness defense mechanism comprising one or both of:

a manual mechanism comprising an overruling or restart setting in exposure settings for said lithographic process which prevents application of wafer alignment feedback and/or triggers a restart of the feedback loop; and

a an automatic mechanism which prevents performance of feedback corrected modelling when a threshold number of prepare model residuals are outside a range.

27. A method as claimed in any preceding claim, wherein said individually modeling of the non-systematic component comprises modeling said non-systematic component with a different alignment recipe as that used for at least one previous substrate of a present production run.

28. A method as claimed in claim 27, wherein said different alignment recipe differs in one or more of: measurement layout, model and/or regularization thereof, fit weights, and color and/or polarization and/or diffraction order recipe.

29. A method as claimed in any preceding claim, comprising performing a model mapping operation for the alignment model used to model said non-systematic component, the model mapping operation having not been performed for at least some previous substrates of a present production run.

30. A method as claimed in any preceding claim, comprising optimizing the alignment recipe specifically for said substrate, said optimized alignment recipe being used to model said non-systematic component only.

31. A method as claimed in any preceding claim, comprising determining a further correction for said substrate based on overlay metrology from one or more previously exposed substrates.

32. A method for modeling alignment data over a substrate area relating to a substrate being exposed in a lithographic process, the method comprising:

obtaining alignment data relating to said substrate;
determining a systematic component of said alignment data which is relatively stable between different substrates; and
individually modeling the systematic component.

33. A method as claimed in claim 32, wherein said step of determining said systematic component comprises:

fitting a prepare model to respective alignment data from each of a number of previous substrate of a present production run;
subtracting the fitted prepare model from its respective alignment data, to leave prepare model residuals; and
determining a moving average of the prepare model residuals.

34. A method as claimed in claim 33, wherein the prepare model is parameterized to describe most of the non-systematic component of said alignment data when fitted to the alignment data.

35. A method as claimed in claim 33 or 34, wherein the prepare model is a linear model.

36. A method as claimed in any of claims 33 to 35, wherein the prepare model is a four parameter model.

37. A method as claimed in claim 36, wherein the four parameter model is parameterized by translation in a first direction in a substrate plane, translation in as second direction in a substrate plane, rotation and substrate magnification.

38. A method as claimed in any of claims 33 to 37, wherein said moving average is determined per alignment mark on the substrate.

39. A method as claimed in any of claims 33 to 38, wherein said moving average is determined per one or more of: color, polarization, diffraction order, direction, chuck, exposure recipe and measurement layout.

40. A method as claimed in any of claims 33 to 39, comprising updating the moving average of said alignment data relating to said substrate after the lithography exposure of each wafer and/or lot of wafers.

41. A method as claimed in any of claims 33 to 40, wherein said moving average is an exponentially weighted moving average.

42. A method as claimed in any of claims 32 to 41, wherein said individually modeling of the systematic component comprises modeling said systematic component according to a same alignment recipe as has been used to model the systematic component of all previous substrates of a present production run.

43. A method as claimed in any of claims 32 to 42, comprising forwarding the model components from said individually modeling step to a lithographic apparatus for determining a process correction for the substrate.

44. A method as claimed in any preceding claim, comprising measuring said substrate to obtain said alignment data.

45. A computer program comprising program instructions operable to perform the method of any of claims 1 to 44, when run on a suitable apparatus.

46. A non-transient computer program carrier comprising the computer program of claim 45.

47. A processing arrangement comprising:

the non-transient computer program carrier of claim 46; and
a processor operable to run the computer program comprised on said non-transient computer program carrier.

48. A lithographic apparatus comprising:

an alignment sensor;
a patterning device support for supporting a patterning device;
a substrate support for supporting a substrate; and
the processing arrangement of claim 47.

49. A lithographic apparatus as claimed in claim 48, wherein the alignment sensor is operable to measure the substrate to obtain said alignment data.

50. A lithographic apparatus as claimed in claim 48 or 49, operable to use the determined process correction for control of said patterning device and/or substrate support.

Fig. 1

Fig. 2

Fig. 3

Fig. 4

Fig. 5

Europäisches
Patentamt

European
Patent Office

Office européen
des brevets

# EUROPEAN SEARCH REPORT

Application Number

**EP 21 19 1008**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 100 48 782 A1 (ITEMIC AG [DE]) 18 April 2002 (2002-04-18) | 1-3 | INV. G03F7/20 G03F9/00 |
| A | * abstract * * figures 1-4 * * paragraphs [0001], [0011] – [0017], [0022], [0039], [0040] * | 4-15 | |
| | ----- | | |
| A | US 2021/080837 A1 (RIJPSTRA MANOUK [NL] ET AL) 18 March 2021 (2021-03-18) * abstract * * figures 17,18 * * paragraphs [0002], [0272] – [0292] * | 1-15 | |
| | ----- | | |
| A | US 2016/299438 A1 (MOS EVERHARDUS CORNELIS [NL] ET AL) 13 October 2016 (2016-10-13) * abstract * * figures 9,10 * * paragraphs [0002], [0147] – [0192] * | 1-15 | |
| | ----- | | |

TECHNICAL FIELDS
SEARCHED      (IPC)

G03F

The present search report has been drawn up for all claims

| Place of search | Date of completion of the search | Examiner |
|---|---|---|
| Munich | 29 April 2022 | Andersen, Ole |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

..............................................................

& : member of the same patent family, corresponding
document

EPO FORM 1503 03.82 (P04C01)

**EP 4 134 745 A1**

## ANNEX TO THE EUROPEAN SEARCH REPORT
## ON EUROPEAN PATENT APPLICATION NO.

EP 21 19 1008

29-04-2022

| Patent document cited in search report | Publication date | Patent family member(s) | Publication date |
|---|---|---|---|
| DE 10048782 A1 | 18-04-2002 | NONE | |
| US 2021080837 A1 | 18-03-2021 | CN 111512235 A | 07-08-2020 |
| | | EP 3729197 A1 | 28-10-2020 |
| | | JP 2021508078 A | 25-02-2021 |
| | | KR 20200086366 A | 16-07-2020 |
| | | TW 201937301 A | 16-09-2019 |
| | | TW 202121067 A | 01-06-2021 |
| | | US 2021080837 A1 | 18-03-2021 |
| | | WO 2019120826 A1 | 27-06-2019 |
| US 2016299438 A1 | 13-10-2016 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2012218533 A1

- US 10331040 B2